# EUROPEAN PATENT APPLICATION

(11) **EP 4 174 226 A1**
(43) Date of publication of application: **03.05.2023**
(21) Application number: 22200011.9
(22) Date of filing: 06.10.2022
(51) Int. Cl.: D04H 1/4291, A01N 25/34, A41D 13/11, B01D 39/00, C23C 14/20, D04H 1/4334, D04H 1/435, D06M 11/83

(54) **FIBROUS MATERIAL WITH AN ANTIMICROBIAL EFFECT AND A FILTER MEDIUM CONTAINING AT LEAST ONE LAYER OF SUCH MATERIAL**

(30) Priority: 29.10.2021 CZ 20212149
(71) Applicant: Turnex, spol. s r.o., 511 01 Turnov (CZ)
(72) Inventor: Korinek, Josef, 511 01 Turnov (CZ); Korinek, Petr, 511 01 Turnov (CZ)
(74) Representative: Musil, Dobroslav

(57) **Abstract**

The invention relates to a fibrous material with an antimicrobial effect, which contains a carrier layer made of at least one synthetic polymer and at least one metal with an antimicrobial effect, wherein the carrier layer has a basis weight of 0.1 to 200 g/m² and at least one metal with an antimicrobial effect is deposited on the fibers of the carrier layer in the form of a continuous layer having a thickness of 1 to 350 nm. This layer is created by magnetron sputtering technology using electromagnetic plasma.

In addition, the invention relates to a filter medium which contains at least one layer of this fibrous material with an antimicrobial effect.

## Description

### Technical field

The invention relates to a fibrous material with an antimicrobial effect which contains a fibrous carrier layer and at least one metal-based active agent with an antimicrobial effect.

The invention also relates to a filter medium containing at least one layer of such material.

### Background art

Various types of antimicrobial fibrous materials are currently known, including materials based on nanofibers and/or microfibers that contain particles of at least one substance with an antimicrobial effect, e.g., based on metal, such as silver, copper, titanium, etc. The particles of this substance are arranged either in the inter-fiber spaces of this fibrous material, or they are anchored directly in the material of the individual fibers - see, e.g., CZ patent 297697 or CZ patent 300797. The disadvantage of the first variant is that these particles are not arranged in the fibrous material with sufficient resistance, and so they can gradually release from it (and especially from the parts near its surface); the disadvantage of the second variant is that the particles are largely, and some even completely, surrounded by the material of the fibers, which greatly limits their antimicrobial action. Furthermore, the common disadvantage of both variants is the fact that the particles are not, in principle, distributed evenly in the structure of the fibrous material and consequently the antimicrobial properties of the fiber structure are also not uniform - there may be spaces in it with insufficient concentration of the substance with an antimicrobial effect, or, on the contrary, with a too high concentration of this substance.

The object of the invention is to provide a fibrous material with an antimicrobial effect which would not suffer from the disadvantages of known materials.

In addition, the object of the invention is also a filter medium that contains at least one layer of such fibrous material.

### Summary of invention

The fibrous material with an antimicrobial effect according to the invention contains a carrier layer consisting of any fibrous layer with a basis weight of 0.1 to 200 g/m² - a textile of any type, e.g., a non-woven textile of any type, a woven textile of any type, a knitted textile of any type, or a layer of polymeric nanofibers, microfibers, or a layer consisting of a mixture of polymeric nanofibers and microfibers in any ratio - see, e.g., CZ patent 306018. In addition to a separate fibrous layer, the carrier layer of this material can also be formed by a suitable composite containing at least two or more fibrous layers, which can differ from each other in thickness and/or basis weight and/or material and/or internal structure and/or type. The carrier fibrous layer of any type can be combined, if necessary, with at least one additional layer of suitable material of a textile and/or non-textile nature (e.g., metal or plastic foil, grid, mesh, etc.).

The carrier layer preferably consists of fibers from synthetic polymer based on polyolefins, vinyls, esters, polyurethanes or polyamides, or a mixture of fibers of at least two of these, which have advantageous properties for the considered applications - in the field of healthcare, chemical industry, food industry, filtration, or electrical engineering. These materials are sufficiently strong, do not release any components or particles, can withstand moisture and most common chemicals, are harmless to health, yet relatively inexpensive and readily available. Polyolefins, especially polypropylene and polyester, which are easy to process, robust and have a high heat resistance, appear to be the most suitable for use in healthcare (e.g., for the manufacture of filters, face masks, mouth-screens, respirators for filtration of inhaled and/or exhaled air, etc.).

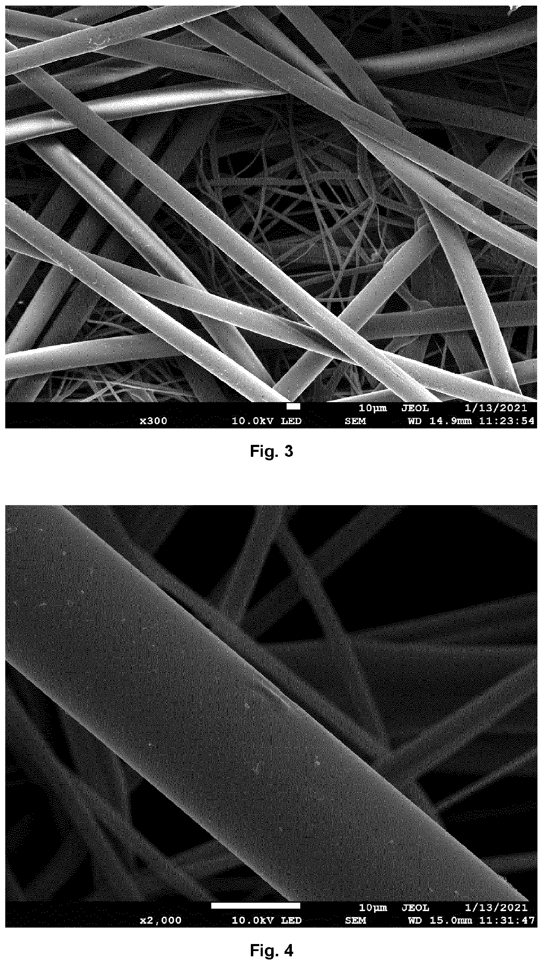

Arranged on the fibers of the carrier layer is also a continuous layer of at least one metal with an antimicrobial effect, such as silver, copper, titanium, aluminium, chromium, iron, gold, platinum, zirconium, etc., or of at least one oxide and/or nitride of such metal with antimicrobial properties. The thickness of this layer is from 1 to 350 nm, preferably especially from 1 to 70 nm (higher thicknesses do not bring an increase in antimicrobial properties corresponding to higher costs). When combining several metals with an antimicrobial effect, it is possible to deposit layers of individual metals with an antimicrobial effect on top of each other (gradual deposition), or to combine a mixture of two or more metals within one layer (simultaneous deposition). The layer of metal/metals is in all variants created by magnetron sputtering technology using electromagnetic high-voltage plasma at low pressure (2×10⁻² Pa) in an inert atmosphere, e.g., argon. The plasma bombards the surface of the fibers of the carrier layer, activates them and creates free radicals, wherein positively charged ions of argon (or of another inert gas in the atmosphere of which the deposition takes place) hit the plate of negatively charged metal deposited on the cathode of the sputtering device (the so-called target), wherein they tear out atoms and partially also metal ions from it, which are subsequently deposited on the fibers of the carrier layer located in the vicinity of magnetrons in a vacuum environment. The metal atoms are deposited on the surface of the fibers of the carrier layer and create a homogenous layer of the given metal around their entire circumference - see, for example, Figs. 3 to 16. The metal layer thus formed has a high adhesion to the fibers of the carrier layer from the physical principle and achieves high purity; moreover, the adhesion of metal atoms and ions to the fibers of the carrier layer is also increased by the energetic particles produced by the plasma. The thickness of the metal layer thus formed depends on the deposition time of the plasma discharge, so it is well regulated and repeatable as required. Due to the very small quantity of applied metal/metals, there is no clogging or significant reduction of the inter-fiber spaces of the carrier layer which thus retains its initial properties - especially breathability, vapor permeability and pressure drop, or permeability for the filtered medium. The carrier fibrous layer can be static during the application of the metal, but preferably it moves (e.g., it is rewound controllably). Due to the fact that the metal atoms released from the target move along paths in the shape of a helix, or a spiral, they are deposited evenly around the entire circumference of the individual fibers of the carrier layer.

If necessary, the metal application is repeated with the same or a different metal, either from the same or opposite side of the carrier fiber layer, to achieve the desired antimicrobial effect.

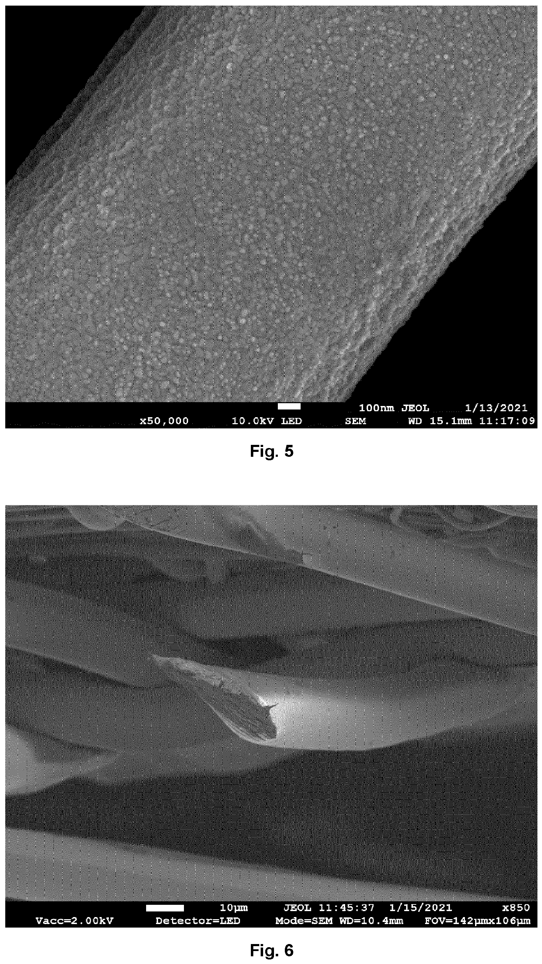

The surface of the formed metal layer is usually not smooth - it contains sharp edges and protrusions that are capable of mechanically destroying or disrupting the biological contaminants that come into contact with them - see Fig. 5, which shows an SEM image of a 50 nm thick layer of silver deposited on a polypropylene fiber at a magnification of 50,000 times, from which the rough structure of the surface of this layer is visible.

Biological contaminants (viruses and bacteria) present in the filtered medium are electrostatically attracted by the layer of metal with an antimicrobial effect (these contaminants carry a negative charge, metals with an antimicrobial effect carry a positive charge) and are subsequently destroyed without residue by the action of this metal. For example, when silver interacts with bacteria, the silver first punctures the bacterial cell wall with its sharp edges, then accumulates on the bacterial surface, and then penetrates through the disrupted cell wall into the cell, where it accumulates in the cytoplasmic membrane, where the main enzymatic systems of the bacteria are present. In doing so, it generates free radicals that destroy cellular functions (see, for example, Jana Rihova Ambrozova et al: "Study of biocidal effects of silver nanoparticles", available from: https://tvp.vscht.cz/files/uzel/0010739/C8rMvC9LVEasLsiPiXdMLklUcM0rC81zz s9NzYs3MiA0iTcEAA.pdf?redirected or KIM J.S. and coll.: "Antimicrobial effects of silver nanoparticles", Nanomedicine: Nanotechnology, Biology and Medicine, 3:95-101.); at the same time it also blocks electron transfer between the enzymes of the respiratory chain and reacts with -SH- groups of oxidative enzymes, thus stopping the cell metabolism and, as a result, the cell gradually dies (see, e.g., Wu and coll.: "Comparative eco-toxicities of nano-ZnO particles under aquatic and aerosol exposure modes". Environmental Science and Technology, 44: 1484-1489).

The entire process usually takes 2 to 3 minutes.

The fibrous material with an antimicrobial effect according to the invention has numerous uses in the field of filtration of gaseous and liquid media, especially air and water, but also in the field of healthcare, chemical industry, food industry and, thanks to its electrical conductivity, also in electrical engineering. For practical use, it is advisable to add at least one additional layer of suitable material to this material, which will provide it with mechanical support and/or protection against mechanical damage, when it will, for example, serve for rough precleaning of the filtered medium before its contact with this material, etc. Such a layer can be, for example, another fibrous layer of any of the above-mentioned types with/without a substance with an antimicrobial effect, a layer of any filter material, e.g., textile, filter paper, or a reinforcing grid or mesh (metal or plastic), perforated foils (metal or plastic), etc. The material created in this way can, for example, be part of various types of filters, such as air filters for air conditioners and similar systems of buildings or vehicles, or fixed or replaceable filters of personal protective equipment, such as masks, half-masks, veils, facecloths, respirators, etc., when it is able to capture and destroy biological contaminants from both inhaled and exhaled air. The use of this material does not necessarily require inserting a new layer into the filter structure - a layer of metal/metals with an antimicrobial effect can be applied to one/some of its standard fibrous layers during the production of this filter.

When used in electrical engineering, this material can then be used, for example, as a flexible material for shielding electromagnetic radiation - due to the continuous layer of electrically conductive metal, it is electrically conductive.

In order to achieve suitable properties for the contemplated application, at least one metal, metal oxide and/or metal nitride having antimicrobial properties may be combined within the layer on the surface of the fibers of the carrier layer with any other metal, metal oxide and/or metal nitride with an antimicrobial effect or also without antimicrobial properties.

For illustration purposes, several examples of antimicrobial fibrous material according to the invention are presented below, including description of the method of their preparation. Analogously, a layer of any metal can be deposited on any type of fibrous material based on synthetic polymer/polymers, since they undergo identical processes, regardless of the internal structure of the material or the dimensions, or diameters of the fibers. With the same technology, substantially any metal can be applied to any material based on synthetic polymer/polymers, including nanofibers, microfibers, or their mixtures.

### Brief description of drawings

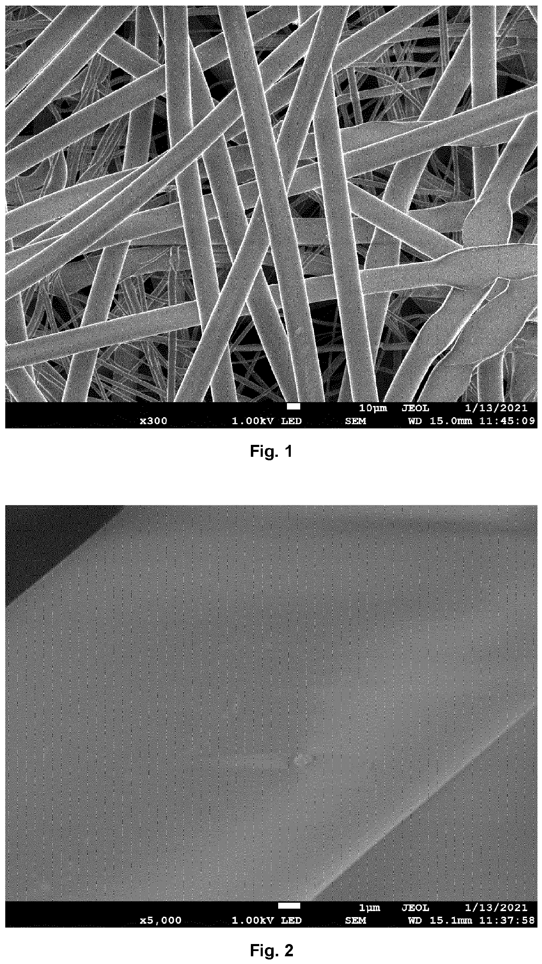

In the enclosed drawings, Fig. 1 shows an SEM image of a textile composite consisting of three layers of non-woven polypropylene fabric with spunbond-meltblown-spunbond composition and a total basis weight of 35 g/m² at a magnification of 300 times, and Fig. 2 shows an SEM image of a fiber of the composite at a magnification of 5,000 times.
Fig. 3 shows an SEM image of the composite with a layer of silver having a thickness of 50 nm deposited on its fibers at a magnification of 300 times, Fig. 4 shows an SEM image of the composite with a layer of silver deposited on its fibers at a magnification of 2,000 times and Fig. 5 shows an SEM image of the layer of silver deposited on composite fiber at a magnification of 50,000 times. Fig. 6 shows an SEM image of a cross-section of the composite fiber with the deposited layer of silver at a magnification of 850 times.

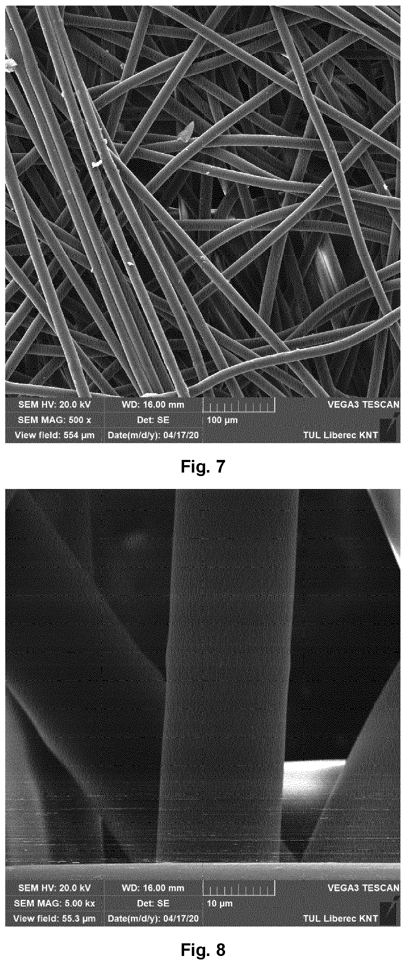

Fig. 7 shows an SEM image of a textile composite consisting of three layers of non-woven polypropylene fabric with a spunbond-meltblown-spunbond composition and a total basis weight of 35 g/m² with a layer of copper having a thickness of 20 nm deposited on its fibers at a magnification of 500 times, and Fig. 8 shows an SEM image of the composite with the layer of copper at a magnification of 5,000 times.

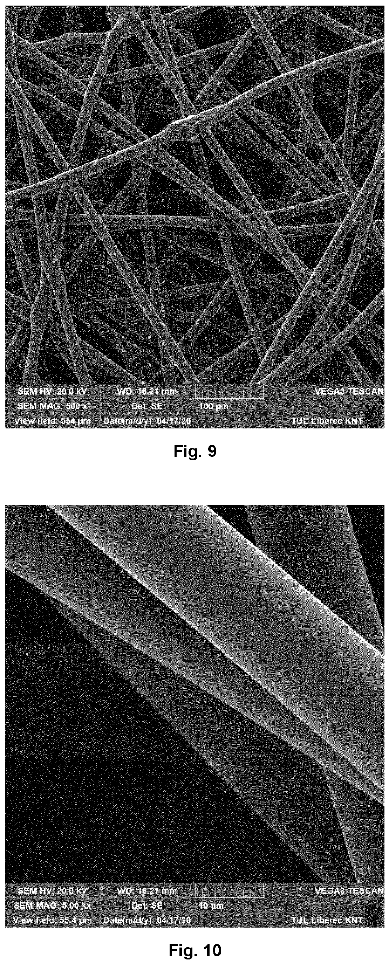

Fig. 9 shows an SEM image of a textile composite consisting of three layers of non-woven polypropylene fabric with a spunbond-meltblown-spunbond composition and a total basis weight of 35 g/m² with a layer of copper of a thickness of 40 nm deposited on its fibers at a magnification of 500 times, and Fig. 10 shows an SEM image of the composite with the layer of copper at a magnification of 5,000 times.

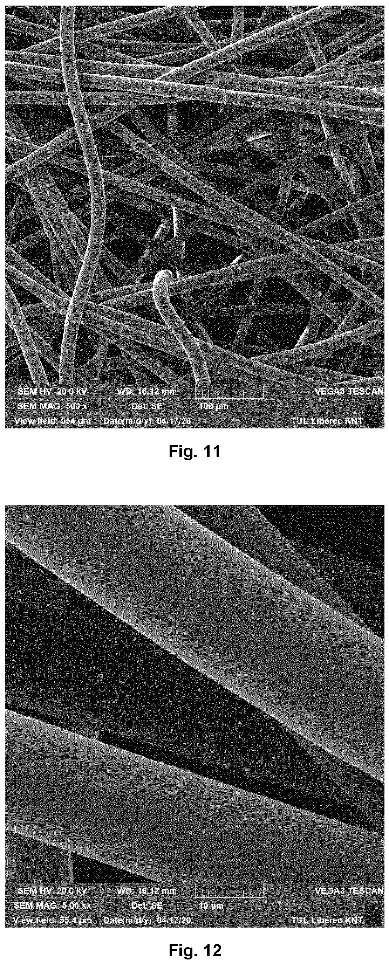

Fig. 11 shows an SEM image of a textile composite consisting of three layers of non-woven polypropylene fabric with a spunbond-meltblown-spunbond composition and a total basis weight of 35 g/m² with a layer of copper having a thickness of 60 nm deposited on its fibers at a magnification of 500 times, and Fig. 12 shows an SEM image of the composite with the layer of copper at a magnification of 5,000 times.

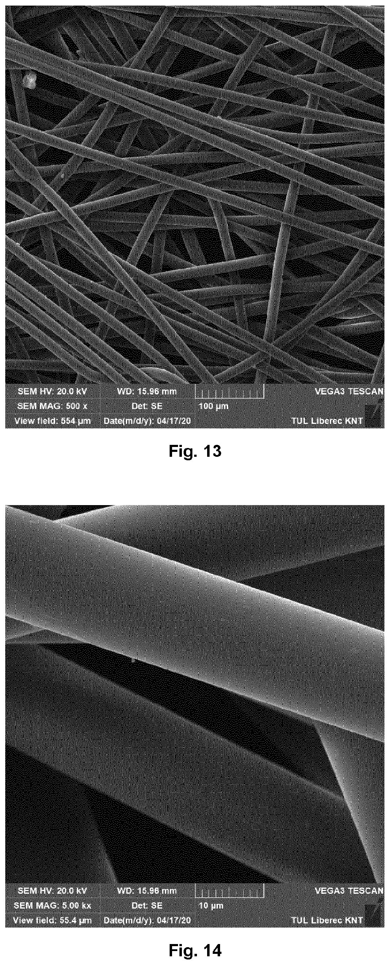

Fig. 13 shows an SEM image of a textile composite consisting of three layers of non-woven polypropylene fabric with a spunbond-meltblown-spunbond composition and a total basis weight of 35 g/m² with a layer of titanium having a thickness of 10 nm deposited on its fibers at a magnification of 500 times, and Fig. 14 shows an SEM image of the composite with the layer of titanium at a magnification of 5,000 times.

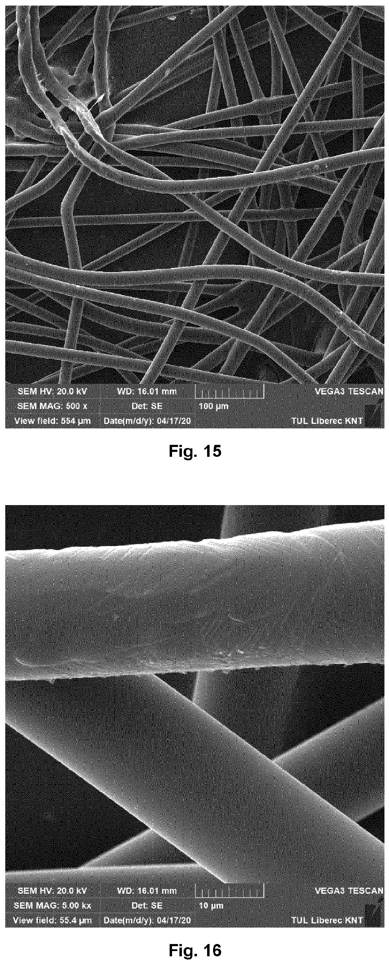

Fig. 15 shows an SEM image of a textile composite consisting of three layers of non-woven polypropylene fabric with a spunbond-meltblown-spunbond composition and a total basis weight of 35 g/m² with a layer of copper and silver having a total thickness of 70 nm deposited on its fibers at a magnification of 500 times, and Fig. 16 shows an SEM image of the composite with the layer of copper and silver at a magnification of 5,000 times.

### Examples of embodiment

### Example 1

A homogenous and continuous layer of silver with a thickness of 50 nm was applied to a sample of a textile composite consisting of three layers of non-woven polypropylene fabric with spunbond-meltblown-spunbond composition and total basis weight of 35 g/m² by magnetron sputtering technology using electromagnetic plasma in an argon atmosphere at a pressure of 1×10⁻² Pa.

Figs. 1 and 2 are SEM images of the starting composite before the layer of silver was applied - in Fig. 1 at a magnification of 300 times and Fig. 2 at a magnification of 5,000 times. In Figure 1, in addition to the fibers of the top layer of the spunbond composite, the fibers of the meltblown layer below are also visible. From both images, it is apparent that the fibers of the starting composite are homogeneous and smooth.

Figs. 3 to 5 are SEM images of the composite with the layer of silver applied to it - in Fig. 3 at a magnification of 300 times, in Fig. 4 at a magnification of 2,000 times and in Fig. 5 at a magnification of 50,000 times. All these images show that the layer of silver is continuous and homogeneous. Figure 5 shows the relatively rough surface texture of the deposited layer of silver, which is capable of mechanically damaging the captured biological contaminants.

Figure 6 further shows an SEM image of a cross-section of the composite fiber with the deposited layer of silver at a magnification of 850 times, in which can be seen the layer of silver deposited on the fiber composite and its thickness.

A sample of this fibrous material was tested using the Antibacterial Activity Assessment of Textile Materials: Parallel Streak Method (AATCC 147). In this method, an 18 × 18 cm sample of the composite with a layer of silver deposited was placed on the surface of agar on which bacteria *Escherichia coli* (CCM 2024) had previously been deposited in several stripes and pressed against it. Then, for 24 hours, the bacteria were cultivated in a thermostat at a temperature of 37 °C. After the end of cultivation, the inhibition of bacteria under the sample and the size of the inhibition zone (so-called halo zone) were evaluated. 100% inhibition of bacteria occurred under the composite sample, with the inhibition zone extending width of the composite sample on each side by approximately 1 mm. This proves that silver ions are released from the sample, which act even outside of direct contact with the sample.

The same test was then repeated with bacteria *Staphylococcus aureus* (CCM 2260), with the difference that the cultivation took place at a temperature of 25 °C. Also in this case, 100% inhibition was achieved, with an overlap of the inhibition zone of approximately 0.2 mm.

In addition, a sample of the fibrous material was also tested using the method according to CSN EN ISO 20743 - Textiles - Determination of the antibacterial effect of antibacterially treated products (AATCC 100 Assessment of Antibacterial Finishes on Textile materials). In the test, an 18 × 18 cm sample of the composite was wetted with 100 µl of inoculum with a concentration of bacteria *Escherichia coli* (CCM 2024) of 10⁵ CFU/ml, and then the bacteria were cultivated in a thermostat at a temperature of 37 °C for 24 hours. After the end of cultivation, 10 ml of physiological solution was added to the sample and the entire mixture was vortexed. Then 1 ml was pipetted from it, which was inoculated onto a Petri dish with blood agar (Columbia, Bio-Rad **LTD.),** and then the number of surviving bacterial colonies (CFU) was determined. The number of the surviving bacterial colonies was 0 in the given case.

The same test was then repeated with bacteria *Staphylococcus aureus* (CCM 2260), with the difference that the cultivation took place at a temperature of 25 °C. Also in this case, the number of surviving bacterial colonies was 0.

### Example 2

A homogenous and continuous layer of silver having a thickness of 15 nm was applied to a sample of a textile composite consisting of three layers of non-woven polypropylene fabric with spunbond-meltblown-spunbond composition and a total basis weight of 35 g/m² by magnetron sputtering technology using electromagnetic plasma in an argon atmosphere at a pressure of 1×10⁻² Pa.

As in example 1, a sample of this fibrous material was tested by the Antibacterial Activity Assessment of Textile materials: Parallel Streak Method AATCC 147 with bacteria *Escherichia coli* (CCM 2024) and *Staphylococcus aureus* (CCM 2260). In both cases, more than 90% inhibition was achieved, with an overlap of the inhibition zone of approximately 0.1 mm.

In addition, as in example 1, a sample of the fibrous material was also tested using the method according to CSN EN ISO 20743 - Textiles - Determination of the antibacterial effect of antibacterially treated products (AATCC 100 Assessment of Antibacterial Finishes on Textile materials) with bacteria *Escherichia coli* (CCM 2024) and *Staphylococcus aureus* (CCM 2260). In the first case, the number of surviving bacterial colonies was 2, in the second 0.

### Example 3

Layers of silver of different thicknesses according to Table 1 were applied to different samples of non-woven spunbond polypropylene fabric and of a textile composite consisting of three layers of non-woven polypropylene fabric with spunbond-meltblown-spunbond (S-M-S) composition by magnetron sputtering technology using electromagnetic plasma in an argon atmosphere at a pressure of 1×10⁻² Pa. In each case, the deposited layer was homogenous. The difference in the thickness of the deposited layer of silver was achieved by extending the application time.

**Table 1**

| **Carrier layer** | **Basis weight of carrier layer (g/m²)** | **Thickness of deposited layer of silver (nm)** | | | | |
|---|---|---|---|---|---|---|
| Polypropylene spunbond | 17 | 6 | 15 | 60 | 135 | |
| | 23 | 6 | 15 | 60 | 135 | |
| | 40 | 6 | 15 | 60 | 110 | 135 |
| | 50 | 6 | 15 | 60 | 110 | 135 |
| | 200 | 6 | 15 | 60 | 110 | 135 |
| Polypropylene composite (S-M-S) | 35 | 6 | 15 | 60 | 135 | |
| | 50 | 6 | 15 | 60 | 135 | |
| | 60 | 6 | 15 | 60 | 135 | |
| | 80 | 6 | 15 | 60 | 110 | 135 |

In all variants, the fibrous material thus prepared had very good antimicrobial effects.

### Example 4

Layers of copper of different thicknesses according to Table 2 were applied to different samples of non-woven spunbond polypropylene fabric and of a textile composite consisting of three layers of non-woven polypropylene fabric with spunbond-meltblown-spunbond (S-M-S) composition by magnetron sputtering technology using electromagnetic plasma in an argon atmosphere at a pressure of 1×10⁻² Pa. In each case, the deposited layer was homogenous. The difference in the thickness of the deposited layer of silver was achieved by extending the application time.

**Table 2**

| **Carrier layer** | **Basis weight of carrier layer (g/m²)** | **Thickness of deposited layer of copper (nm)** | | | | |
|---|---|---|---|---|---|---|
| Polypropylene spunbond | 17 | 12 | 55 | 125 | 178 | 350 |
| | 23 | 12 | 55 | 125 | 178 | 350 |
| | 50 | 12 | 55 | 125 | 178 | 350 |
| Polyester spunbond | 40 | 12 | 55 | 125 | 178 | 350 |
| | 200 | 12 | 55 | 125 | 178 | 350 |
| Polypropylene composite (S-M-S) | 35 | 20 | 40 | 60 | 178 | 350 |
| | 50 | 125 | | | | |
| | 60 | 12 | 55 | 125 | 178 | 350 |
| | 80 | 12 | 55 | 125 | 178 | 350 |

Fig. 7 shows an SEM image of a textile composite consisting of three layers of non-woven polypropylene fabric with spunbond-meltblown-spunbond composition and a total basis weight of 35 g/m² with a layer of copper having a thickness of 20 nm deposited on its fibers at a magnification of 500 times, and Fig. 8 shows an SEM image of this composite with the layer of copper at a magnification of 5,000 times.

Fig. 9 shows an SEM image of a textile composite consisting of three layers of non-woven polypropylene fabric with spunbond-meltblown-spunbond composition and a total basis weight of 35 g/m² with a layer of copper having a thickness of 40 nm deposited on its fibers at a magnification of 500 times, and Fig. 10 shows an SEM image of this composite with the layer of copper at a magnification of 5,000 times.

Fig. 11 shows an SEM image of a textile composite consisting of three layers of non-woven polypropylene fabric with spunbond-meltblown-spunbond composition and total basis weight of 35 g/m² with a layer of copper having a thickness of 60 nm deposited on its fibers at a magnification of 500 times, and Fig. 12 shows an SEM image of this composite with the layer of copper at a magnification of 5,000 times.

In all variants, the fibrous material thus prepared had very good antimicrobial effects.

### Example 5

Layers of titanium of different thicknesses according to Table 3 were applied to different samples of non-woven spunbond polypropylene fabric, non-woven spunbond polyester fabric and of a textile composite consisting of three layers of non-woven polypropylene fabric with spunbond-meltblown-spunbond (S-M-S) composition by magnetron sputtering technology using electromagnetic plasma in at a pressure of 1×10⁻² Pa an argon atmosphere. In each case, the deposited layer was homogenous. The difference in the thickness of the deposited layer of titanium was achieved by extending the application time.

**Table 3**

| **Carrier layer** | **Basis weight of carrier layer (g/m²)** | **Thickness of deposited layer of titanium (nm)** | | | | |
|---|---|---|---|---|---|---|
| Polypropylene spunbond | 17 | 6 | 15 | 29 | 105 | 180 |
| | 23 | 15 | 29 | 105 | 180 | |
| | 50 | 6 | 15 | 29 | 105 | 180 |
| Polyester spunbond | 40 | 6 | 15 | 29 | 105 | 180 |
| | 200 | 6 | 15 | 29 | 105 | 180 |
| Polypropylene composite (S-M-S) | 35 | 10 | 29 | 105 | 180 | |
| | 50 | 6 | 15 | 29 | 105 | 180 |
| | 60 | 6 | 15 | 29 | 105 | 180 |
| | 80 | 6 | 15 | 29 | 105 | 180 |

Fig. 13 shows an SEM image of a textile composite consisting of three layers of non-woven polypropylene fabric with spunbond-meltblown-spunbond composition and a total basis weight of 35 g/m² with a layer of titanium having a thickness of 10 nm deposited on its fibers at a magnification of 500 times, and Fig. 14 shows an SEM image of this composite with the layer of titanium at a magnification of 5,000 times.

In all variants, the fibrous material thus prepared had very good antimicrobial effects.

### Example 6

Layers of aluminium of different thicknesses according to Table 4 were applied to different samples of spunbond non-woven polyester fabric and a textile composite consisting of three layers of non-woven polypropylene fabric with spunbond-meltblown-spunbond (S-M-S) composition by magnetron sputtering technology using electromagnetic plasma in an argon atmosphere at a pressure of 1×10⁻² Pa. In each case, the deposited layer was homogenous. The difference in the thickness of the deposited layer of aluminium was achieved by extending the application time.

**Table 4**

| **Carrier layer** | **Basis weight of carrier layer (g/m²)** | **Thickness of deposited layer of aluminium (nm)** | | | |
|---|---|---|---|---|---|
| Polypropylene spunbond | 17 | 7 | 28 | 150 | 170 |
| | 23 | 7 | 28 | 150 | 170 |
| | 50 | 7 | 28 | 150 | 170 |
| Polyester spunbond | 40 | 7 | 28 | 150 | 170 |
| | 200 | 7 | 28 | 150 | 170 |
| Polypropylene composite (S-M-S) | 35 | 7 | 28 | 150 | 170 |
| | 50 | 7 | 28 | 150 | 170 |
| | 60 | 7 | 28 | 150 | 170 |
| | 80 | 7 | 28 | 150 | 170 |

In all variants, the fibrous material prepared in this manner had very good antimicrobial effects.

### Example 7

A homogenous and continuous layer of copper having a thickness of 25 nm and after that, a layer of silver having a thickness of 15 nm were applied to a sample of a textile composite consisting of three layers of non-woven polypropylene fabric with spunbond-meltblown-spunbond composition and a total basis weight of 35 g/m² by magnetron sputtering technology using electromagnetic plasma in an argon atmosphere at a pressure of 1×10⁻² Pa.

As in example 1, the sample of this fibrous material was tested by the Antibacterial Activity Assessment of Textile materials: Parallel Streak Method AATCC 147 with bacteria *Escherichia coli* (CCM 2024) and *Staphylococcus aureus* (CCM 2260). In both cases, more than 90% inhibition was achieved, with an overlap of the inhibition zone of approximately 0.2 mm in the case of *Escherichia coli* and approximately 0.1 mm in the case of *Staphylococcus aureus.*

In addition, as in example 1, a sample of this fibrous material was tested using a method according to CSN EN ISO 20743 - Textiles - Determination of the antibacterial effect of antibacterially treated products (AATCC 100 Assessment of Antibacterial Finishes on Textile materials) with bacteria *Escherichia coli* (CCM 2024) and *Staphylococcus aureus* (CCM 2260). In the first case, the number of surviving bacterial colonies was 3, in the second 0.

### Example 8

A homogenous and continuous layer of copper having a thickness of 40 nm and after that, a layer of silver having a thickness of 30 nm were applied to a sample of a textile composite consisting of three layers of non-woven polypropylene fabric with spunbond-meltblown-spunbond composition and a total basis weight of 35 g/m² by magnetron sputtering technology using electromagnetic plasma in an argon atmosphere at a pressure of 1×10⁻² Pa.

As in example 1, the sample of this fibrous material was tested by the Antibacterial Activity Assessment of Textile materials: Parallel Streak Method AATCC 147 with bacteria *Escherichia coli* (CCM 2024) and *Staphylococcus aureus* (CCM 2260). In both cases, 100% inhibition was achieved, with an overlap of the inhibition zone of approximately 1 mm in the case of *Escherichia coli* and approximately 0.2 mm in the case of *Staphylococcus aureus.*

In addition, as in example 1, a sample of this fibrous material was tested using a method according to CSN EN ISO 20743 - Textiles - Determination of the antibacterial effect of antibacterially treated products (AATCC 100 Assessment of Antibacterial Finishes on Textile materials) with bacteria *Escherichia coli* (CCM 2024) and *Staphylococcus aureus* (CCM 2260). In the first case, the number of surviving bacterial colonies was 1, in the second 0.

### Example 9

A homogenous and continuous layer of copper having a thickness of 20 nm and after that, a layer of silver of a thickness of 15 nm were applied to a sample of a textile composite consisting of three layers of non-woven polypropylene fabric with spunbond-meltblown-spunbond composition and a total basis weight of 50 g/m² by magnetron sputtering technology using electromagnetic plasma in an argon atmosphere at a pressure of 1×10⁻² Pa.

As in example 1, the sample of this fibrous material was tested by the Antibacterial Activity Assessment of Textile materials: Parallel Streak Method AATCC 147 with bacteria *Escherichia coli* (CCM 2024) and *Staphylococcus aureus* (CCM 2260). In the case of *Escherichia coli* more than 80% inhibition was achieved, in the case of *Staphylococcus aureus* more than 90% inhibition with an overlap of the inhibition zone of approximately 0.1 mm.

In addition, as in example 1, a sample of this fibrous material was tested using a method according to CSN EN ISO 20743 - Textiles - Determination of the antibacterial effect of antibacterially treated products (AATCC 100 Assessment of Antibacterial Finishes on Textile materials) with bacteria *Escherichia coli* (CCM 2024) and *Staphylococcus aureus* (CCM 2260). In the first case, the number of surviving bacterial colonies was 2, in the second case 0.

### Example 10

A homogenous and continuous layer of copper having a thickness of 40 nm and after that, a layer of silver having a thickness of 30 nm were applied to a sample of a textile composite consisting of three layers of non-woven polypropylene fabric with spunbond-meltblown-spunbond composition and a total basis weight of 50 g/m² by magnetron sputtering technology using electromagnetic plasma in an argon atmosphere at a pressure of 1×10⁻² Pa.

As in example 1, the sample of this fibrous material was tested by the Antibacterial Activity Assessment of Textile materials: Parallel Streak Method AATCC 147 with bacteria *Escherichia coli* (CCM 2024) and *Staphylococcus aureus* (CCM 2260). In both cases, 100% inhibition was achieved with an overlap of the inhibition zone of approximately 1 mm in the case of *Escherichia coli* and approximately 0.2 mm in the case of *Staphylococcus aureus.*

In addition, as in example 1, a sample of this fibrous material was tested using a method according to CSN EN ISO 20743 - Textiles - Determination of the antibacterial effect of antibacterially treated products (AATCC 100 Assessment of Antibacterial Finishes on Textile materials) with bacteria *Escherichia coli* (CCM 2024) and *Staphylococcus aureus* (CCM 2260). In both cases, the number of surviving bacterial colonies was 0.

Fig. 15 shows an SEM image of this textile composite at a magnification of 500 times, and Fig. 16 shows an SEM image of this composite at a magnification of 5,000 times.

## Claims

1. A fibrous material with an antimicrobial effect which contains a carrier fibrous layer from at least one synthetic polymer and at least one metal with an antimicrobial effect, **characterized in that** the carrier layer has a basis weight of 0.1 to 200 g/m² and at least one metal with an antimicrobial effect is deposited on the fibers of the carrier layer in the form of a continuous layer having a thickness of 1 to 350 nm.

2. The fibrous material with an antimicrobial effect according to claim 1, **characterized in that** the metal with an antimicrobial effect is silver, copper, titanium, chromium, iron, gold, platinum or zirconium.

3. The fibrous material with an antimicrobial effect according to claim 1, **characterized in that** the carrier fibrous layer is formed by fibers based on polyolefins, vinyls, esters, polyurethanes or polyamides.

4. The fibrous material with an antimicrobial effect according to claim 1 or 3, **characterized in that** the carrier fibrous layer consists of a layer of polymeric nanofibers.

5. The fibrous material with an antimicrobial effect according to claim 1 or 3, **characterized in that** the carrier fibrous layer consists of a layer of polymeric microfibers.

6. The fibrous material with an antimicrobial effect according to claim 1 or 3, **characterized in that** the carrier fibrous layer consists of a mixture of polymeric nanofibers and microfibers.

7. The fibrous material with an antimicrobial effect according to any of claims 1 to 6, **characterized in that** a layer of one metal with an antimicrobial effect is deposited on the fibers of the carrier fibrous layer, wherein a layer of a different metal with an antimicrobial effect is deposited thereon.

8. The fibrous material with an antimicrobial effect according to any of claims 1 to 6, **characterized in that** a layer of a mixture of at least two metals with an antimicrobial effect is deposited on the fibers of the carrier fibrous layer.

9. A filter medium, **characterized in that** it contains at least one layer of fibrous material with an antimicrobial effect according to any of claims 1 to 8.
